# EUROPEAN PATENT SPECIFICATION

(11) **EP 2 677 536 B1**
(45) Date of publication and mention of the grant of the patent: **25.03.2020**
(21) Application number: 12747252.0
(22) Date of filing: 16.02.2012
(51) Int. Cl.: H01L 21/316, H01L 21/76, H01L 21/768, H01L 23/522, H01L 23/532, H01L 21/762

(54) **METHOD FOR PRODUCING SILICON DIOXIDE FILM**
VERFAHREN ZUR HERSTELLUNG EINER SILICIUMDIOXIDSCHICHT
PROCÉDÉ DE PRODUCTION D'UNE PELLICULE DE DIOXYDE DE SILICIUM

(30) Priority: 17.02.2011 JP 2011032099
(43) Date of publication of application: 25.12.2013
(73) Proprietor: Merck Patent GmbH, 64293 Darmstadt (DE)
(72) Inventor: NAGAHARA Tatsuro, Kakegawa-shi Shizuoka 437-1412 (JP); HAYASHI Masanobu, Kakegawa-shi Shizuoka 437-1412 (JP); SUZUKI Katsuchika, Kakegawa-shi Shizuoka 437-1412 (JP)
(74) Representative: Rippel, Hans Christoph
(86) International application number: PCT/JP2012/053605
(87) International publication number: WO 2012/111729

(56) References cited:
- EP-A1- 0 781 815
- JP-A- 2000 198 160
- JP-A- 2005 045 230
- JP-A- 2005 045 230
- JP-A- 2008 273 913
- JP-A- 2008 273 913
- JP-A- 2012 060 000
- US-A1- 2010 173 470

## Description

### TECHNICAL FIELD

The present invention relates to a method for forming silicon dioxide films in electronic devices. Specifically, this invention relates to a method for forming silicon dioxide films used for providing insulating films in electronic devices, for example, for providing shallow trench isolation structures, in manufacture of electronic devices such as semiconductor elements.

### BACKGROUD ART

In an electronic device such as a semiconductor element, semiconductor parts such as transistors, resistors and the like are generally arranged on a substrate. Those parts must be electrically insulated from each other, and hence it is necessary to provide isolation structures among the parts so as to separate them.

Meanwhile, in the field of electronic devices, the density and integration degree have been increased in recent years. According to the increase of the density and integration degree, it has become difficult to form isolation structures minute enough to meet the needed integration degree and hence it has been required to develop new isolation structures satisfying the needs. Those new isolation structures include a trench isolation structure, which is formed by carving fine trenches on the surface of a semiconductor substrate and then filling the trenches with insulating material so as to electrically separate a part positioned on one side from another part on the other side of each trench. The structure thus separating the parts can reduce the isolation area, as compared with the conventional structures, and is accordingly effective in achieving the high integration degree required in these days. In addition, if the parts are layered three-dimensionally to increase the density, it is also necessary to provide an insulating layer between layers of electro-conductive material. As the insulating layer, a pre-metal dielectric (PMD) or inter-metal dielectric (IMD) film is usable.

As a method for forming the isolation structure, there is a known process in which a substrate surface having a trench structure is coated with a composition containing a polysilazane compound to fill the trenches in and then fired to form an oxide film.

The firing procedure is normally carried out in a water vapor atmosphere. However, for the purpose of promoting oxidation of the polysilazane compound, there is a known technique of performing the firing procedure in the presence of hydrogen peroxide.

For example, Patent document 1 discloses a process of forming a SOG film by use of dehydration condensation of perhydrosilazane polymer. In that process, the dehydration condensation is conducted through heat treatment in an atmosphere containing moisture (H₂O) and ozone (O₃), but it is also disclosed that the heat treatment can be carried out in a hydrogen peroxide atmosphere. The patent document, however, does not clearly describe the firing temperature but only gives examples in which the firing procedure was performed at about 400°C. The firing temperature is hence high in the process disclosed in the patent document. Further, according to the description of the document, the process is intended to be applied to formation of, what is called, inter-layer dielectric films but not to formation of, for example, silicon oxide films on plastic bases and the like.

Patent document 2 also discloses a process in which a coat of polysilazane is fired in hydrogen peroxide vapor to obtain a ceramic film. The firing temperature thereof ranges from 500 to 1800°C.

However, the present inventors have found that, if the firing procedure is carried out at a high temperature, scattered objects in the atmosphere affect the coat to make the resultant silicon dioxide film liable to suffer from increases of shrinkage and of film stress. This means that, in view of the properties, there is room for improvement in silicon dioxide films formed according to Patent documents 1 and 2.

Further, Patent document 3 discloses a process in which a plastic film is coated with polysilazane and then brought into contact with an amine compound and/or an acid compound so as to convert the polysilazane into SiO₂ type ceramic. This patent document refers to hydrogen peroxide as an example of the acid compound, and actually says that the polysilazane was dried at 25°C in the presence of hydrogen peroxide vapor and then fired in a water vapor atmosphere at 95°C/85%RH to obtain a silicon oxide film. However, according to the present inventors' study, there is room for further improvement to obtain a silicon dioxide film having excellent properties. Specifically, the inventors have found that, when the oxide film is formed under the conditions described in Patent document 3, hydrogen peroxide vapor by itself functions as an initiator of oxidation reaction rather than as a promoter of the reaction and, on the other hand, the oxidation reaction in itself occurs in the water vapor treatment, which is carried out after the contact with hydrogen peroxide vapor. Further, the oxide film thus formed in the process of Patent document 3 is found to contain a nonnegligible amount of silanol groups (Si-OH groups). Those silanol groups experience dehydration condensation in the course of the firing procedure performed successively, to form a silicon dioxide film after all. Even so, however, it is also found that the oxide film suffers from shrinkage caused by elimination of water in the dehydration condensation.

### PRIOR ART DOCUMENTS

### PATENT DOCUMENTS

[Patent document 1] Japanese Patent Laid-Open No. 9(1997)-275135
[Patent document 2] U.S. Patent No. 5,055,431
[Patent document 3] Japanese Patent Laid-Open No. 9(1997)-183663, paragraph [0067]

Further documents relevant to the present disclosure are JP 2008 273913 A, US 2010/173470 A1, and EP 0 781 815 A1. In particular, US 2010/173470 A1 discloses a method for forming a silicon dioxide film in electronic devices, comprising (A) a coating step, in which a substrate is coated with a polysilazane composition to form a coat, and (B) an oxidation step, in which the coat is oxidized in a ozone atmosphere at a temperature of 120°C, furthermore comprising a step of annealing, in which the coat is heated at a temperature of 300 to 1000°C after the oxidation step.

### DISCLOSURE OF INVENTION

### PROBLEM TO BE SOLVED BY THE INVENTION

In view of the prior arts described above, the present invention aims to provide a method capable of forming an insulating film suffering less from both shrinkage and stress.

### MEANS FOR SOLVING PROBLEM

The present invention resides in a method for forming a silicon dioxide film in electronic devices, comprising
(A) a coating step, in which a substrate is coated with a polysilazane composition to form a coat; and
(B) an oxidation step, in which the coat is oxidized in a hydrogen peroxide atmosphere at a temperature of 50 to 200°C, furthermore comprising
a step of oxidation with water vapor, in which the coat is heated in a water vapor atmosphere at a temperature of 300 to 1000°C after the oxidation step.

The present invention also resides in a method for forming an isolation structure in electronic devices; wherein the above method is applied to form a silicon dioxide film on a substrate having a trench structure on the surface, so as to fill in grooves of the structure.

### EFFECT OF THE INVENTION

The present invention enables to form a silicon dioxide film having excellent properties in a short time, as compared with conventional methods. Since containing fewer silanol groups, the silicon dioxide film formed according to the present invention is particularly characterized by suffering less from both shrinkage and stress.

### BEST MODE FOR CARRYING OUT THE INVENTION

### Formation process of silicon dioxide film

The method of the present invention for forming a silicon dioxide film is partly characterized by comprising an oxidation step in which a coat containing polysilazane is heated under a hydrogen peroxide atmosphere within a particular temperature range so as to convert the polysilazane into silicon dioxide. As described above, it is already known that polysilazane is oxidized in the presence of hydrogen peroxide and thereby converted into silicon dioxide. However, if the temperature is too high, low molecular weight components originally contained in the coat and/or formed during the oxidation treatment are scattered or sublimated even in the case where the polysilazane is heated under a hydrogen peroxide atmosphere. As a result, the resultant silicon dioxide film often suffers from large shrinkage. On the other hand, however, if the temperature is too low, the oxidation reaction in itself hardly proceeds and also the hydrogen peroxide vapor cannot penetrate into the coat enough to promote the oxidation reaction. Accordingly, in order to obtain a silicon dioxide film having satisfying properties, the step of firing must be conducted under particular preferred conditions. The silicon dioxide film-formation method of the present invention, which comprises the above oxidation step, is explained below in detail.

### (A) Coating step

First, a substrate is prepared on which a silicon dioxide film is intended to be formed. In the method of the present invention for forming a silicon dioxide film, the heating temperature in the oxidation step is relatively low and hence materials of the substrate can be selected from a wider range than in normal silicon dioxide film-formation methods. For example, it can be freely selected from semiconductor substrates such as silicon substrates, inorganic substrates such as glass substrates, organic substrates such as plastic substrates, and so on. When formed on a surface of the substrate, the silicon dioxide film can be made to have various functions. For example, it can be made to function as an insulating film constituting a shallow trench isolation structure that separates parts arranged on the substrate surface, or otherwise it can be used as an inter-layer dielectric film if circuit structures are layered on the substrate.

In the case where a shallow trench isolation structure is intended to be formed, a substrate having a trench structure, namely, having relief grooves on the surface is prepared. Any method can be adopted to form the grooves on the substrate surface. Concrete procedures thereof are, for example, as follows.

In the first procedure, a silicon dioxide layer is formed on the surface of, for example, a silicon substrate by, for example, the thermal oxidation method. The silicon dioxide layer is generally made to have a thickness of 5 to 30 nm.

According to necessity, a silicon nitride layer is then deposited on the formed silicon dioxide layer by, for example, the low-pressure CVD method. The silicon nitride layer will function as a mask in the following etching procedure or as a stop layer in the polishing procedure described later. If formed, the silicon nitride layer is so deposited as to have a thickness of generally 100 to 400 nm.

The silicon dioxide or silicon nitride layer thus formed is then coated with a photoresist. After dried or hardened if necessary, the photoresist coat is subjected to exposure according to a desired pattern and then developed to form the pattern. The exposure can be carried out in any manner such as mask exposure or scanning exposure. The photoresist can be also freely selected in view of resolution and the like.

By use of the formed photoresist film as a mask, the silicon nitride layer and the silicon dioxide layer laid thereunder are etched in order. As a result of this procedure, the desired pattern is formed on the silicon nitride layer and the silicon dioxide layer.

The silicon substrate is then subjected to dry-etching by use of the patterned silicon nitride and silicon dioxide layers as a mask, to form trench isolation grooves.

The widths of the formed trench isolation grooves depend on the pattern used in the exposure of the photoresist coat. In general, the widths of trench isolation grooves in semiconductor elements are properly selected according to the aimed elements. However, in the present invention, the groove width is preferably 5 to 50 nm, more preferably 5 to 40 nm. The aspect ratio, which is a ratio of the groove depth to the width, is preferably 10 to 100, more preferably 10 to 50.

In the next procedure, the silicon substrate thus prepared is coated with a polysilazane composition serving as a material of the silicon dioxide film, to form a coat. The polysilazane composition can be prepared by dissolving any known polysilazane compound in a solvent.

The polysilazane compound used in the present invention is not particularly restricted, and hence can be freely selected unless it impairs the effect of the invention. It may be either an inorganic or organic compound. Preferred examples of the polysilazane compound include a polysilazane comprising the following units (Ia) to (Ic) in combination: 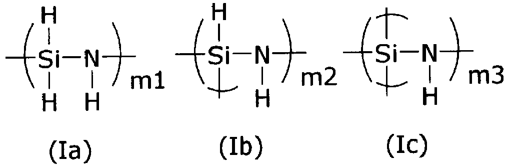 (wherein each of m1 to m3 is a number indicating the polymerization degree).

It is particularly preferred for the above polysilazane to have a polystyrene-reduced weight average molecular weight of 700 to 30000.

Examples of the polysilazane compound also include: a polysilazane which has a skeleton mainly represented by the following formula (II): 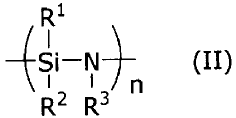 (wherein each of R¹, R² and R³ is independently a hydrogen atom, an alkyl group, an alkenyl group, a cycloalkyl group, an aryl group, an alkylsilyl group, an alkylamino group, an alkoxy group, or another group, such as a fluoroalkyl group, which contains a carbon atom directly connecting to the silicon atom, provided that at least one of R¹, R² and R³ is a hydrogen atom; and n is a number indicating the polymerization degree) and which has a number average molecular weight of about 100 to 50000; and modified compounds thereof. Two or more of the above polysilazane compounds can be used in combination.

The polysilazane composition used in the present invention contains a solvent capable of dissolving the above polysilazane compound. The solvent used here is different from that used in the aforementioned impregnating solution. There are no particular restrictions on the solvent as long as it can dissolve the above components. Preferred examples of the solvent include:
(a) aromatic compounds, such as benzene, toluene, xylene, ethylbenzene, diethylbenzene, trimethylbenzene and triethylbenzene; (b) saturated hydrocarbon compounds, such as n-pentane, i-pentane, n-hexane, i-hexane, n-heptane, i-heptane, n-octane, i-octane, n-nonane, i-nonane, n-decane and i-decane; (c) alicyclic hydrocarbon compounds, such as ethylcyclohexane, methylcyclohexane, cyclohexane, cyclohexene, p-menthane, decahydronaphthalene, dipentene and limonene; (d) ethers, such as dipropyl ether, dibutyl ether, diethyl ether, methyl tertiary butyl ether (hereinafter, referred to as MTBE) and anisole; and (e) ketones, such as methyl isobutyl ketone (hereinafter, referred to as MIBK). Among them, more preferred are (b) saturated hydrocarbon compounds, (c) alicyclic hydrocarbon compounds, (d) ethers and (e) ketones.

Those solvents can be used in combination of two or more, so as to control the evaporation rate, to reduce the hazardousness to the human body and to control the solubility of the components.

The polysilazane composition used in the present invention can contain other additives, if necessary. Examples of the optional additives include crosslinking accelerators that promote the crosslinking reaction of polysilazane, catalysts of the reaction converting into silicon dioxide, and viscosity modifiers for controlling viscosity of the composition. Further, when used for producing a semiconductor devise, the composition can contain a phosphorus compound such as tris(trimethylsilyl)phosphate for the sake of Na-gettering effect.

The contents of the above components depend on the coating conditions and the firing conditions. However, the polysilazane composition contains the polysilazane compound in an amount of preferably 1 to 40 wt%, more preferably 2 to 35 wt%, based on the total weight of the composition. Nevertheless, this by no means restricts the concentration of polysilazane in the polysilazane composition, and the composition having any polysilazane concentration can be adopted as long as it can form a trench isolation structure defined in the present invention. The amount of each of the various components other than polysilazane varies according to what additive is used, but is preferably 0.001 to 40 wt%, more preferably 0.005 to 30 wt%, further preferably 0.01 to 20 wt%, based on the weight of the polysilazane compound.

The polysilazane composition can be cast on the substrate according to any coating method, such as, spin coating, curtain coating, dip coating and the like. Among them, spin coating is particularly preferred in consideration of evenness of the formed coat. The thickness of the coat is preferably 5 to 10000 nm, more preferably 20 to 5000 nm. Here, if the substrate has a surface provided with grooves and the like, the above "thickness of the coat" means the thickness in the area where the grooves and the like are not provided. If being too thick, the coat is often oxidized so unevenly that the oxidation reaction insufficiently proceeds near the substrate surface. On the other hand, however, it should be noted that, if the coat is too thin, it is often impossible to form a silicon dioxide film having a sufficient thickness.

### (B) Oxidation step

After the coating step, the polysilazane coat is heated in a hydrogen peroxide atmosphere to convert the whole coat into a silicon dioxide film. In the course of heating, the polysilazane is converted into silicon dioxide to form an insulating film. The heating procedure can be carried out by means of any apparatus, such as, a hardening furnace or a hot-plate, as long as the temperature and the hydrogen peroxide atmosphere can be controlled. It is particularly preferred that the apparatus be a system in which hydrogen peroxide water supplied therein can be converted into a hydrogen peroxide atmosphere. For example, a hot-plate can be used to prepare an apparatus for the oxidation step in the following manner. First, a hot-plate is covered to form a closed space above the plate. The coated substrate is then placed in the closed space, and then hydrogen peroxide water is dropped therein. The drops of hydrogen peroxide water are vaporized by heat of the hot-plate, to produce a hydrogen peroxide atmosphere in the closed space. In this way, it can be realized to satisfy the conditions of the oxidation step in the present invention.

If hydrogen peroxide is supplied in the form of hydrogen peroxide water, the concentration thereof may be generally in the range of 5 to 90 wt%. However, it is easy and preferred to use commercially available 30 w/v% hydrogen peroxide water.

Since the oxidation reaction is accelerated to improve the production efficiency, the hydrogen peroxide atmosphere preferably contains a high concentration of hydrogen peroxide. Accordingly, the concentration is preferably 5 mol% or more, further preferably 7 mol% or more. However, if it is too high, there is a risk of explosion. The concentration is hence preferably so selected as to be below the lower explosive limit. Although the lower explosive limit depends on temperature, the hydrogen peroxide concentration is preferably not more than 50 mol%, further preferably not more than 28 mol%.

The hydrogen peroxide atmosphere can further contain water vapor. If the atmosphere contains water vapor, the oxidation reaction of polysilazane is expected to be accelerated. Hydrogen peroxide is normally distributed in the form of hydrogen peroxide water, and hence it is easy to produce a water vapor-containing hydrogen peroxide atmosphere from hydrogen peroxide water. If the atmosphere contains a low concentration of water vapor, it is also expected to inhibit formation of silanol groups during the heating procedure. Accordingly, the concentration of water vapor is preferably 5 to 90 mol%, more preferably 20 to 80 mol% in the atmosphere. The atmosphere may further contain an inert gas such as nitrogen or argon.

The temperature in the oxidation step depends on various conditions such as the kind of the used polysilazane composition and the combination of the steps. However, at a high temperature, the polysilazane compound generally tends to be rapidly converted into silicon dioxide, to increase the production efficiency. However, if the oxidation treatment is conducted at too high a temperature, low molecular weight components originally contained in the coat and/or formed during the treatment are scattered or sublimated and, as a result, the resultant silicon dioxide film often suffers from large shrinkage. Further, if the substrate is made of silicon, the silicon substrate may undergo oxidization and, as a result, the properties of the device may deteriorate. In view of this, the oxidation step is carried out at a temperature of necessarily 200°C or less, preferably 180°C or less. On the other hand, however, the temperature is necessarily 50°C or more, preferably 70°C or more, further preferably 100°C or more. If necessary, the heating temperature can be step-by-step changed in the oxidation step. The present invention thus enables to form a silicon dioxide film at a relatively low temperature, and the formed silicon dioxide film suffers less from shrinkage and stress. The present invention, therefore, is effective in forming an anti-abrasive film, a passivation film, a primer film or the like on the surface of a base made of plastics, such as, acrylic resin, polyethylene terephthalate, and polycarbonate.

The heating time in the oxidation step is so selected that the oxidation reaction can proceed sufficiently, and is generally 0.5 to 60 minutes, preferably 1 to 30 minutes.

In the course of heating, the polysilazane compound in the coat is converted into silicon dioxide to form a silicon dioxide film. The silicon dioxide film thus formed undergoes small shrinkage and low film stress, and also has excellent properties such as high etching durability.

The method of the present invention for forming a shallow trench isolation structure indispensably comprises the above (A) and (B) steps, but may further comprises the following auxiliary steps in combination according to necessity.

### (a) Step of removing the solvent

After the coating step and before the firing step, the substrate coated with the polysilazane composition can be subjected to pre-baking. This step is carried out for the purpose of removing the solvent at least partly from the coat.

In the step of removing the solvent, the substrate is normally heated at an essentially constant temperature. This step should be carried out under the conditions that the polysilazane does not substantially undergo oxidation or polymerization. Accordingly, the temperature in the step of removing the solvent is normally 200°C or below, preferably 150°C or below, more preferably 100°C or below. On the other hand, however, in order to remove the solvent sufficiently, the temperature is normally 50°C or more. The time for pre-baking is generally 0.5 to 10 minutes, preferably 1 to 5 minutes. The temperature in this step is generally so selected as not to be higher than the temperature in the oxidation step performed successively. That is for the purpose of reducing scattered objects to the utmost.

### (b) Step of oxidation with water vapor

After subjected to the oxidation step, the substrate is further heated in a water vapor atmosphere so as to further promote the oxidation reaction. The oxidation with water vapor is preferably carried out in an inert gas or oxygen atmosphere containing water vapor by use of a hardening furnace or a hot-plate. Water vapor is effective in sufficiently converting the polysilazane compound into silicon dioxide, and the water vapor content in the atmosphere is preferably 1 mol% or more, further preferably 10 mol% or more, furthermore preferably 20 mol% or more. It is particularly preferred that the water vapor content be 20 mol% or more. If so, the oxidation reaction smoothly proceeds and consequently defects such as voids are formed less to improve the properties of the resultant silicon dioxide film. In the case where the inert gas is adopted as the atmospheric gas, nitrogen, argon and helium are usable.

In the step of oxidation with water vapor, the temperature depends on various conditions such as the kind of the used polysilazane composition and the combination of the steps. At a high temperature, the oxidation reaction tends to proceed rapidly and hence the production efficiency tends to increase. On the other hand, if the substrate is made of silicon, the silicon substrate is apt to suffer less from oxidization and the crystal structure thereof is apt to change less, and accordingly the properties of the device are deteriorated less. Even if the substrate is heated at a higher temperature in the step of oxidation with water vapor than in the prior oxidation step, the properties of the resultant film are hardly impaired by scattered objects. That is because the oxidation reaction already proceeded at a low temperature in the prior oxidation step. In view of this, the temperature in the step of oxidation with water vapor is 300 to 1000°C, further preferably 350 to 700°C. According to necessity, the heating temperature and the water vapor content can be step-by-step changed in the step of oxidation with water vapor.

### (c) Optional polishing step

After the oxidation step, unnecessary parts of the formed silicon dioxide film are preferably removed. In the polishing step, the silicon dioxide film formed on the flat surface of the substrate is removed by polishing while that formed in the grooves is left. This procedure is a polishing step. The polishing step may be carried out after the hardening treatment or immediately after the step of removing the solvent if that step is performed in combination.

The polishing step is generally performed according to a CMP process. The CMP process can be carried out by use of normal abrasives and abrasive apparatus. Examples of the abrasives include silica, alumina, ceria, and aqueous suspension dispersing those and, if necessary, other abrasives. The abrasive apparatus is, for example, a commercially available normal CMP apparatus.

### (d) Optional etching step

As a result of the above polishing step, the silicon dioxide film formed from the polysilazane composition is almost removed from the flat surface of the substrate. However, for removing the residual silicon dioxide film remaining on the flat surface, etching treatment is preferably performed. In the etching treatment, etching solution is generally used. There are no particular restrictions on the etching solution as long as it can remove the residual silicon dioxide film. The etching solution is normally a hydrofluoric acid aqueous solution containing ammonium fluoride. The content of ammonium fluoride in the solution is preferably 5% or more, more preferably 30% or more.

The present invention is further explained below by use of the following examples.

### Example 1 (effect of hydrogen peroxide)

A silicon substrate was spin-coated with a polysilazane solution (20 wt% dibutyl ether solution) at 1000 rpm and then subjected to pre-baking at 70°C for 3 minutes, to obtain a polysilazane coat of 600 nm thickness. The coated substrate was placed on a hot-plate heated at 150°C and then covered with a quartz-made Petri dish provided with a hole of about 3 mm diameter. Hydrogen peroxide water (30 wt%) was then dropped through the hole at the rate of 0.2 cc/minute. Touching the hot-plate, the dropped hydrogen peroxide water was vaporized and diffused homogeneously in the Petri dish. The concentrations of hydrogen peroxide and water vapor in the Petri dish at that time were estimated to be about 25 mol% and 75 mol%, respectively. This oxidation treatment was conducted for 10 minutes. The obtained silicon dioxide film was subjected to IR spectroscopic measurement. As a result, it was found that almost all the silazane bonds in the polysilazane were converted into siloxane bonds and also found that silanol groups were hardly left.

After the IR spectroscopic measurement, the coated substrate was further heated at 850°C for 30 minutes in a nitrogen atmosphere. Thereafter, the shrinkage ratio, dielectric constant and breakdown voltage of the obtained silicon dioxide film were measured to obtain the results shown in Table 1.

### Comparative example 1

The procedures of Example 1 were repeated except that pure water was dropped in place of hydrogen peroxide water, to heat the coated substrate. After the heating treatment, the coat was subjected to IR spectroscopic measurement. As a result, it was found that the oxidation reaction hardly proceeded and hence that the polysilazane was almost the same as before the treatment.

### Comparative example 2

In the same manner as in Example 1, a silicon substrate was coated with a polysilazane solution to form a polysilazane coat. The obtained sample was left in a hot water vapor atmosphere of 80%H₂O/O₂ at 350°C for 30 minutes, and then heated in a nitrogen atmosphere at 850°C for 30 minutes. Thereafter, the shrinkage ratio, dielectric constant and breakdown voltage of the obtained silicon dioxide film were measured to obtain the results shown in Table 1.

### Comparative example 3

In the same manner as in Example 1, a silicon substrate was coated with a polysilazane solution to form a polysilazane coat. Meanwhile, a 30 wt% aqueous solution of hydrogen peroxide was kept at 40°C and then placed in an airtight container. The atmosphere in the container was so controlled that the temperature and the relative humidity were 25°C and 60%, respectively. The sample was placed in the container for 10 minutes, and successively left in a water vapor atmosphere of 95°C temperature and 80% relative humidity for 5 minutes. Subsequently, the sample was further heated in a nitrogen atmosphere at 850°C for 30 minutes. The silicon dioxide film thus obtained was subjected to IR spectroscopic measurement. As a result, the film showed an IR spectrum having a broad peak at about 3300 cm⁻¹. That peak was attributed to silanol groups, and hence it indicated that the oxidation reaction proceeded insufficiently. The shrinkage ratio, dielectric constant and breakdown voltage of the obtained silicon dioxide film were measured to obtain the results shown in Table 1

### [Table 1]

**Table 1**

| Properties | Example 1 | Comparative Example 2 | Comparative Example 3 |
|---|---|---|---|
| Shrinkage ratio (%) | 12 | 19 | 25 |
| Stress (MPa) | -10 | +20 | +100 |
| Dielectric constant | 3.7 | 3.7 | 4.5 |
| Breakdown voltage (MV/cm) | 6.8 | 6.5 | 3.2 |

In the table, the signs of "+" and "-" stand for tensile stress and compressive stress, respectively.

The above results indicate that the silicon dioxide film obtained in Example 1 achieved excellent shrinkage ratio and breakdown voltage. Further, although a silicon dioxide film is known to generally have a dielectric constant of about 3.5 to 4.0, the film of Comparative example 3 had a higher dielectric constant. This suggests that the reaction proceeded insufficiently, and accordingly the film is presumed to contain remaining nitrogen atoms. As for the stress, the favorable range thereof depends on what the silicon dioxide film is used for. However, if intended to serve as an insulating film used for an isolation structure, the silicon dioxide film preferably undergoes low stress. The silicon dioxide film of Example 1 is also excellent in view of that.

### Examples 2 and 3

The procedures of Example 1 were repeated except that the concentration of hydrogen peroxide water was changed into 10 mol% (Example 2) or 5 mol% (Example 3), to heat the polysilazane coat. When heated for 10 minutes, the coats of Examples 2 and 3 experienced the oxidation reaction still insufficiently. The heating procedure was, therefore, continued. As a result, the coats of Examples 2 and 3 were found to experience the oxidation reaction to the same degree as that of Example 1 when heated for 15 minutes and 40 minutes, respectively.

## Claims

1. A method for forming a silicon dioxide film in electronic devices, comprising
(A) a coating step, in which a substrate is coated with a polysilazane composition to form a coat; and
(B) an oxidation step, in which the coat is oxidized in a hydrogen peroxide atmosphere at a temperature of 50 to 200°C, furthermore comprising
a step of oxidation with water vapor, in which the coat is heated in a water vapor atmosphere at a temperature of 300 to 1000°C after the oxidation step.

2. The method according to claim 1 for forming a silicon dioxide film, wherein the oxidation step is carried out at a temperature of 100 to 200°C.

3. The method according to claim 1 or 2 for forming a silicon dioxide film, wherein the hydrogen peroxide atmosphere contains 5 to 50 mol% of hydrogen peroxide in the oxidation step.

4. The method according to any of claims 1 to 3 for forming a silicon dioxide film, wherein the hydrogen peroxide atmosphere contains 5 to 50 mol% of water vapor in the oxidation step.

5. The method according to any of claims 1 to 4 for forming a silicon dioxide film, wherein the heating time ranges from 0.5 to 60 minutes in the oxidation step.

6. The method according to any of claims 1 to 5 for forming a silicon dioxide film, further comprising
a step of removing the solvent after the coating step and before the oxidation step.

7. The method according to any of claims 1 to 6 for forming a silicon dioxide film, wherein the polysilazane composition contains solid content in an amount of 1 to 40 wt% based on the total weight of the composition.

8. The method according to any of claims 1 to 7 for forming a silicon dioxide film, wherein the coat formed in the coating step has a thickness of 5 to 10000 nm.

9. The method according to any of claims 1 to 8 for forming a silicon dioxide film, wherein the substrate is made of plastics.

10. A method for forming an isolation structure in electronic devices; wherein the method according to any of claims 1 to 9 is applied to form a silicon dioxide film on a substrate having grooves or holes on the surface, so as to fill the grooves or holes in.

11. The method according to claim 10 for forming an isolation structure, wherein the silicon dioxide film serves as an inter-metal dielectric film or as a pre-metal dielectric film.

12. The method according to claim 10 for forming an isolation structure, wherein the silicon dioxide film constitutes a shallow trench isolation structure.

13. The method according to claim 12 for forming an isolation structure, wherein the grooves have widths of 5 to 50 nm and aspect ratios of 10 to 100.

## Patentansprüche

1. Verfahren zur Bildung eines Siliziumdioxidfilms in elektronischen Geräten, umfassend
(A) einen Beschichtungsschritt, in dem ein Substrat mit einer Polysilazan-Zusammensetzung beschichtet wird, um eine Beschichtung zu bilden; und
(B) einen Oxidationsschritt, in dem die Beschichtung in einer Wasserstoffperoxid-Atmosphäre bei einer Temperatur von 50 bis 200 °C oxidiert wird, des Weiteren umfassend einen Schritt der Oxidation mit Wasserdampf, in dem die Beschichtung nach dem Oxidationsschritt in einer Wasserdampfatmosphäre bei einer Temperatur von 300 bis 1000 °C erhitzt wird.

2. Verfahren gemäß Anspruch 1 zur Bildung eines Siliziumdioxidfilms, wobei der Oxidationsschritt bei einer Temperatur von 100 bis 200 °C durchgeführt wird.

3. Verfahren gemäß Anspruch 1 oder 2 zur Bildung eines Siliziumdioxidfilms, wobei die Wasserstoffperoxid-Atmosphäre im Oxidationsschritt 5 bis 50 Mol% Wasserstoffperoxid enthält.

4. Verfahren gemäß einem beliebigen der Ansprüche 1 bis 3 zur Bildung eines Siliziumdioxidfilms, wobei die Wasserstoffperoxid-Atmosphäre im Oxidationsschritt 5 bis 50 Mol% Wasserdampf enthält.

5. Verfahren gemäß einem beliebigen der Ansprüche 1 bis 4 zur Bildung eines Siliziumdioxidfilms, wobei die Zeit des Erhitzens im Oxidationsschritt im Bereich von 0,5 bis 60 Minuten liegt.

6. Verfahren gemäß einem beliebigen der Ansprüche 1 bis 5 zur Bildung eines Siliziumdioxidfilms, des Weiteren umfassend
einen Schritt des Entfernens des Lösungsmittels nach dem Beschichtungsschritt und vor dem Oxidationsschritt.

7. Verfahren gemäß einem beliebigen der Ansprüche 1 bis 6 zur Bildung eines Siliziumdioxidfilms, wobei die Polysilazan-Zusammensetzung einen Feststoffgehalt in einer Menge von 1 bis 40 Gew.-% hat, bezogen auf das Gesamtgewicht der Zusammensetzung.

8. Verfahren gemäß einem beliebigen der Ansprüche 1 bis 7 zur Bildung eines Siliziumdioxidfilms, wobei die im Beschichtungsschritt gebildete Beschichtung eine Stärke von 5 bis 10000 nm hat.

9. Verfahren gemäß einem beliebigen der Ansprüche 1 bis 3 zur Bildung eines Siliziumdioxidfilms, wobei das Substrat aus Plastik gemacht ist.

10. Verfahren zur Bildung einer Isolationsstruktur in elektronischen Geräten; wobei das Verfahren gemäß einem beliebigen der Ansprüche 1 bis 9 angewandt wird, um einen Siliziumdioxidfilm auf einem Substrat mit Furchen und Löchern auf der Oberfläche zu bilden, sodass die Furchen und Löcher gefüllt werden.

11. Verfahren gemäß Anspruch 10 zur Bildung einer Isolationsstruktur, wobei der Siliziumdioxidfilm als intermetall-dielektrischer Film oder als prä-metall-dielektrischer Film dient.

12. Verfahren gemäß Anspruch 10 zur Bildung einer Isolationsstruktur, wobei der Siliziumdioxidfilm eine flache Grabenisolationsstruktur darstellt.

13. Verfahren gemäß Anspruch 12 zur Bildung einer Isolationsstruktur, wobei die Furchen Breiten von 5 bis 50 nm und Seitenverhältnisse von 10 bis 100 haben.

## Revendications

1. Procédé pour la formation d'une couche de dioxyde de silicium dans des dispositifs électroniques, comprenant
(A) une étape de revêtement, dans laquelle un substrat est revêtu avec une composition de polysilazane pour former un revêtement ; et
(B) une étape d'oxydation, dans laquelle le revêtement est oxydé dans une atmosphère renfermant du peroxyde d'hydrogène à une température de 50 à 200 °C, comprenant en outre
une étape d'oxydation avec de la vapeur d'eau, dans laquelle le revêtement est chauffé dans une atmosphère renfermant de la vapeur d'eau à une température de 300 à 1000 °C après l'étape d'oxydation.

2. Procédé selon la revendication 1 pour la formation d'une couche de dioxyde de silicium, dans lequel l'étape d'oxydation est effectuée à une température de 100 à 200 °C.

3. Procédé selon la revendication 1 ou 2 pour la formation d'une couche de dioxyde de silicium, dans lequel l'atmosphère renfermant du peroxyde d'hydrogène contient 5 à 50 % en mole de peroxyde d'hydrogène dans l'étape d'oxydation.

4. Procédé selon l'une quelconque des revendications 1 à 3 pour la formation d'une couche de dioxyde de silicium, dans lequel l'atmosphère renfermant du peroxyde d'hydrogène contient 5 à 50 % en mole de vapeur d'eau dans l'étape d'oxydation.

5. Procédé selon l'une quelconque des revendications 1 à 4 pour la formation d'une couche de dioxyde de silicium, dans lequel la durée de chauffage va de 0,5 à 60 minutes dans l'étape d'oxydation.

6. Procédé selon l'une quelconque des revendications 1 à 5 pour la formation d'une couche de dioxyde de silicium, comprenant en outre
une étape d'élimination du solvant après l'étape de revêtement et avant l'étape d'oxydation.

7. Procédé selon l'une quelconque des revendications 1 à 6 pour la formation d'une couche de dioxyde de silicium, dans lequel la composition de polysilazane contient une teneur en extrait sec en une quantité de 1 à 40 % en poids par rapport au poids total de la composition.

8. Procédé selon l'une quelconque des revendications 1 à 7 pour la formation d'une couche de dioxyde de silicium, dans lequel le revêtement formé dans l'étape de revêtement a une épaisseur de 5 à 10000 nm.

9. Procédé selon l'une quelconque des revendications 1 à 8 pour la formation d'une couche de dioxyde de silicium, dans lequel le substrat est constitué de matière plastique.

10. Procédé pour la formation d'une structure d'isolation dans des dispositifs électroniques ; dans lequel le procédé selon l'une quelconque des revendications 1 à 9 est appliqué pour former une couche de dioxyde de silicium sur un substrat ayant des rainures ou des trous sur la surface, de manière à combler les rainures ou les trous.

11. Procédé selon la revendication 10 pour la formation d'une structure d'isolation, dans lequel la couche de dioxyde de silicium sert de couche diélectrique entre des couches de métal ou de couche diélectrique avant une couche de métal.

12. Procédé selon la revendication 10 pour la formation d'une structure d'isolation, dans lequel la couche de dioxyde de silicium constitue une structure d'isolation par tranchées peu profondes.

13. Procédé selon la revendication 12 pour la formation d'une structure d'isolation, dans lequel les rainures ont des largeurs de 5 à 50 nm et des facteurs de forme de 10 à 100.
